# EUROPEAN PATENT APPLICATION

(11) **EP 1 170 632 A1**
(43) Date of publication of application: **09.01.2002**
(21) Application number: 00906609.3
(22) Date of filing: 01.03.2000
(51) Int. Cl.: G03F 7/004, C08L 101/00

(54) **PHOTOSENSITIVE RESIN COMPOSITION FOR ROLL COATING AND METHOD OF ROLL COATING**

(30) Priority: 19.03.1999 JP 7573999
(71) Applicant: Clariant International Ltd., 4132 Muttenz 1 (CH)
(72) Inventor: YAMAMOTO, Kenji, Ogasa-gun Shizuoka 437-1496 (JP)
(74) Representative: Hütter, Klaus, Dr.
(86) International application number: JP0001208
(87) International publication number: WO0057248

(57) **Abstract**

Intended to provide a radiation sensitive resin composition for roller coating which can provide a resist layer with scarcely forming uneven coating when applied by a roller coating method, and a roller coating method using the radiation sensitive resin composition. The radiation sensitive resin composition for roller coating comprises an alkali-soluble resin, a photosensitizer and a nonionic fluorine-based or silicon-based surface active agent, and is applied onto a substrate by a roller coating method. Preferred examples of the nonionic fluorine-based surface active agent include a polyalkylene oxide adduct of perfluoroalkyl(C₃ to C₁₂) sulfonamide, a polyalkylene oxide adduct of perfluoroalkyl(C₃ to C₁₂)ethyl alcohol and a mixture of (a) a copolymer between an ester of acrylic acid with perfluoroalkyl(C₃ to C₁₂)ethyl alcohol and methyl methacrylate and (b) a polyalkylene oxide. Further, preferred examples of the nonionic silicon-based surface active agent include a polyalkylene oxide adduct of polysiloxane derivative.

## Description

### Technical Field

The present invention relates to a radiation sensitive resin composition for roller coating and, more particularly, to a radiation sensitive resin composition for roller coating which can provide a resist layer with scarcely forming uneven coating when applied by a roller coating method, as well as a roller coating method using the radiation sensitive resin composition.

### Background Art

In manufacturing semiconductor integrated circuit elements, color filters, liquid crystal display elements etc., lithographic technique has conventionally been employed for conducting fine work. In recent years, techniques enabling fine work on the order of sub-micron or sub-quarter micron have been investigated. In such lithographic techniques, a positive- or negative-working radiation sensitive resin composition is coated on a substrate directly or after forming thereon an anti-reflective coating if necessary, and the coated composition is pre-baked to form a radiation sensitive resist film. Then, this radiation sensitive resist film is subjected to e.g. pattern-wise exposure with various kinds of radiation such as ultraviolet rays, deep ultraviolet rays, electron beams, X-rays or the like, and developed to form a resist pattern.

As the method of applying a radiation sensitive resin composition, there have conventionally been known various methods such as a spin coating method, a roller coating method, a land coating method, a cast coating method, a doctor coating method and a dip coating method. Specifically, in manufacturing semiconductor integrated circuit elements or liquid crystal display elements, a positive-working radiation sensitive resin composition as a resist material and a spin coating method as a coating method are often employed. On the other hand, in manufacturing liquid crystal display elements, a roller coating method is often employed as well as a spin coating method as a coating method.

By the way, in using the spin coating method as the method of applying a radiation sensitive resin composition on a substrate, a resist solution dropped onto the substrate is cast in the outer periphery direction of the substrate by the centrifugal force by the rotation of the substrate, and the majority of the resist solution is scattered and removed as an excess resist solution from the outer periphery of the substrate. The thus-removed resist solution is discarded. Thus, while this spin coating method enables one to form a resist film of uniform thickness with ease, it has the defect that the amount of the discarded resist solution is so large that it imposes high cost. On the other hand, the roller coating method, which can utilize most of the resist solution as a resist layer, serves to reduce manufacturing cost, but has the defect that there arises uneven coating such as streaks and orange peel upon application of a radiation sensitive resin composition. For example, liquid crystal display elements produced using a resist film with such coating unevenness provide non-uniform light areas, thus having no commercial values.

To solve the problem caused by the roller coating, for example, following proposals have been done. That is, from the viewpoint of material, a radiation sensitive resin composition containing a solvent whose boiling point, kinematic viscosity and rate of evaporation are limited (Japanese Patent Application Laid-Open (JP-A) No. 10-186637), a radiation sensitive resin composition containing a mixed solvent containing a solvent selected from propylene glycol and dipropylene glycol (JP-A No. 10-186638), etc. were proposed. In addition, from the viewpoint of process, a method of coating a composition in a predetermined direction and then coating it again in another direction (JP-A No. 62-198853), a method of spray-coating a diluent used as a component in a coating solution onto a face to be coated (JP-A No. 5-237440), and a method of applying a composition onto a major pattern area in the central area of a substrate and then applying it around only the edge of an outer peripheral portion (JP-A No. 8-141490) etc. were proposed.

A variety of improvements have been made as described above, but the conventional methods and materials are disadvantageous in that they need an alternation in process or limitation of coating conditions, or have a problem in cost. Accordingly, there has been demand for a radiation sensitive resin composition for roller coating, which does not need an alternation in process, has large process latitude, is coated at low cost and hardly causes coating unevenness as compared with the conventionally known radiation sensitive resin compositions.

The object of the present invention is to provide a radiation sensitive resin composition free from the above-mentioned problems in roller coating, and more specifically to provide a radiation sensitive resin composition for roller coating which, upon being coated by roller coating method, hardly generates coating unevenness, as well as a roller coating method using the radiation sensitive resin composition.

### Disclosure of the Invention

Conventionally, there has been considered problematic because the use of a surface active agent in a radiation sensitive resist composition for roller coating causes bubbles to form pinholes at the time of coating, thus making it difficult to obtain a defect-free coating film. As a result of eager study and examination, the present inventor has found that a radiation sensitive resin composition having good coating properties not predictable from the prior art can be obtained by incorporating a nonionic fluorine- or silicon-based surface active agent into a radiation sensitive resin composition containing an alkali-soluble resin such as alkali-soluble novolak resin and a photosensitizer such as a naphthoquinone diazide compound, thus have completed the present invention based on the finding.

That is, the present invention relates to a radiation sensitive resin composition for roller coating, which comprises an alkali-soluble resin, a photosensitizer and a nonionic fluorine-based surface active agent.

Further, the present invention relates to a radiation sensitive resin composition for roller coating, which comprises an alkali-soluble resin, a photosensitizer and a nonionic silicon-based surface active agent.

In addition, the present invention relates a method of roller-coating a radiation sensitive resin composition, wherein the above-described radiation sensitive resin composition for roller coating is applied onto a substrate by a roller coating method.

Hereinafter, the present invention is described in more detail.

First, the alkali-soluble resin used in the radiation sensitive resin composition of the present invention is a novolak-based phenol resin obtained by polycondensation between at least one of phenols and an aldehyde such as formalin.

The phenols used for producing this alkali-soluble novolak resin include e.g. cresols such as o-cresol, p-cresol and m-cresol; xylenols such as 3,5-xylenol, 2,5-xylenol, 2,3-xylenol and 3,4-xylenol; trimethylphenols such as 2,3,4-trimethylphenol, 2,3,5-trimethylphenol, 2,4,5-trimethylphenol and 3,4,5-trimethylphenol; t-butylphenols such as 2-t-butylphenol, 3-t-butylphenol and 4-t-butylphenol; methoxyphenols such as 2-methoxyphenol, 3-methoxyphenol, 4-methoxyphenol, 2,3-dimethoxyphenol, 2,5-dimethoxyphenol, and 3,5-dimethoxyphenol; ethylphenols such as 2-ethylphenol, 3-ethylphenol, 4-ethylphenol, 2,3-diethylphenol, 3,5-diethylphenol, 2,3,5-triethylphenol and 3,4,5-triethylphenol; chlorophenols such as o-chlorophenol, m-chlorophenol, p-chlorophenol and 2,3-dichlorophenol; resorcinols such as resorcinol, 2-methylresorcinol, 4-methylresorcinol and 5-methylresorcinol; catechols such as 5-methylcatechol; pyrogallols such as 5-methylpyrogallol; bisphenols such as bisphenols A, B, C, D, E and F; methylolated cresols such as 2,6-dimethylol-p-cresol; and naphthols such as α-naphthol and β-naphthol. These can be used alone or as a mixture thereof.

The aldehydes include, besides formalin, salicylaldehyde, paraformaldehyde, acetaldehyde, benzaldehyde, hydroxy benzaldehyde, chloroacetaldehyde, and the like. These can be used alone or as a mixture thereof.

The alkali-soluble resin used may also be a resin from which low-molecular components have been removed by fractionation. The method of removing low-molecular components by fractionation includes e.g. a liquid-liquid fractionation method in which a resin is fractionated in 2 solvents having different dissolution ability, a method of removing low-molecular components by centrifugation, and a thin-film distillation method.

As the photosensitizer, a photosensitizer containing a quinone diazide group is preferable. This photosensitizer containing a quinone diazide group may be any known photosensitizer conventionally used in quinone diazide-novolak type resist. Such photosensitizer is preferably a compound obtained by allowing naphthoquinone diazide sulfonic acid chloride or benzoquinone diazide sulfonic acid chloride to react with a low-molecular or high-molecular compound having a functional group which is capable of condensation with the acid chloride. The functional group which is capable of condensation with the acid chloride includes a hydroxyl group, an amino group etc., and the hydroxyl group is particularly preferable. The compound which contains a hydroxyl group and is able to condense with an acid chloride includes e.g. hydroquinone; resorcin; hydroxybenzophenones such as 2,4-dihydroxybenzophenone, 2,3,4-trihydroxybenzophenone, 2,4,6-trihydroxybenzophenone, 2,4,4'-trihydroxybenzophenone, 2,3,4,4'-tetrahydroxybenzophenone, 2,2',4,4'-tetrahydroxybenzophenone and 2,2',3,4,6'-pentahydroxybenzophenone; hydroxyphenylalkanes such as bis(2,4-dihydroxyphenyl)methane, bis(2,3,4-trihydroxyphenyl)methane and bis(2,4-dihydroxyphenyl)propane; and hydroxytriphenylmethanes such as 4,4',3",4"-tetrahydroxy-3,5,3',5'-tetramethyl triphenyl methane and 4,4',2",3",4"-pentahydroxy-3,5,3',5'-tetramethyl triphenyl methane. These can be used alone or in combination thereof.

Preferable examples of acid chlorides such as naphthoquinone diazide sulfonic acid chloride and benzoquinone diazide sulfonic acid chloride include 1,2-naphthoquinonediazide-5-sulfonyl chloride and 1,2-naphthoquinonediazide-4-sulfonyl chloride.

The amount of the photosensitizer containing a quinone diazide group is usually 5 to 50 parts by weight, preferably 10 to 40 parts by weight relative to 100 parts by weight of the alkali-soluble resin.

The nonionic fluorine-based surface active agent used in the present invention may be any conventionally known nonionic fluorine-based surface active agent. Examples of the nonionic fluorine-based surface active agent which can be used preferably in the present invention are as follows:
(1) R_{f}SO₂NRCH₂CH₂O(R'O)ₙH (polyalkylene oxide adduct of fluoroalkyl sulfonamide);
   wherein R_{f} represents a C₃ to C₁₂ fluoroalkyl group in which the whole or a part of hydrogen atoms in the alkyl group have been replaced by fluorine atoms, R represents a hydrogen atom or a C₁ to C₅ lower alkyl group, R' represents a C₂ to C₅ lower alkylene group, and n represents an integer of 0 or 1 or more.
(2) A mixture of polyalkylene oxide and a copolymer of R_{f}CH₂CH₂OCOAc (ester between acrylic acid and fluoroalkyl ethyl alcohol) and MMA (methyl methacrylate);
   wherein R_{f} has the same meanings as defined above, and Ac represents a vinyl group.
(3) R_{f}CONRCH₂CH₂O(R'O)ₙH (polyalkylene oxide adduct of fluoroalkyl carboxylic acid amide);
   wherein R_{f}, R, R' and n have the same meanings as defined above.
(4) R_{f}CH₂CH₂O(R'O)ₙH (polyalkylene oxide adduct of fluoroalkyl ethyl alcohol);
wherein R_{f}, R' and n have the same meanings as defined above.

The surface active agents shown in (1) and (2) above are particularly preferable, and the surface active agent shown in (1) includes e.g. Megafac F-142-D and Megafac F-144-D (Dainippon Ink and Chemicals, Inc.). The surface active agent in (2) includes e.g. Megafac F-472 (Dainippon Ink and Chemicals, Inc.), and the surface active agent in (4) includes Fluowet OTN [Clariant (Japan) K.K.] and Fluorad FC-170C (Sumitomo 3M Ltd.).

Further, a typical example of the nonionic silicon-based surface active agent used in the present invention includes e.g. SiR'₃O(SiR"₂O)ₚ(CH₂CH₂O)_{q}H; wherein R' and R" each represent a hydrogen atom, a hydroxyl group, a C₁ to C₅ alkyl group, or O(CH₂CH₂O)ᵣH, and p, q and r each represents a number of 1 or more. An example of this nonionic silicon-based surface active agent is Polyflow KL-245 (Kyoeisha Kagaku Ltd.).

Other preferable examples include Dishome CE-457 and Dishome CK-140 (Nippon Oil and Fats Co., Ltd.) and silicon-based Paintad 32 (Dow Corning Asia Ltd.).

These surface active agents are added usually at a concentration of 200 to 5000 ppm (200×10⁻⁶ to 5000×10⁻⁶ parts by weight) relative to 1.00 part by weight of the total amount of the alkali-soluble resin and the photosensitizer.

The solvent in which the radiation sensitive resin composition of the present invention is dissolved includes ethylene glycol monoalkyl ethers such as ethylene glycol monomethyl ether and ethylene glycol monoethyl ether; ethylene glycol monoalkyl ether acetates such as ethylene glycol monomethyl ether acetate and ethylene glycol monoethyl ether acetate; propylene glycol monoalkyl ethers such as propylene glycol monomethyl ether and propylene glycol monoethyl ether; propylene glycol monoalkyl ether acetates such as propylene glycol monomethyl ether acetate and propylene glycol monoethyl ether acetate; lactates such as methyl lactate and ethyl lactate; aromatic hydrocarbons such as toluene and xylene; ketones such as methyl ethyl ketone, 2-heptanone and cyclohexanone; amides such as N,N-dimethylacetamide and N-methyl pyrrolidone; and lactones such as γ-butyrolactone. These solvents are used alone or in combination thereof.

Dyestuffs, adhesive assistants etc. may be incorporated as necessary to the radiation sensitive resin composition of the present invention. Examples of dyestuffs include Methyl Violet, Crystal Violet, Malachite Green etc., and examples of adhesive assistants include alkyl imidazoline, butyric acid, alkyl acid, polyhydroxystyrene, polyvinyl methyl ether, t-butyl novolak, epoxysilane, epoxy polymers, silane etc.

The roller coating method used for the radiation sensitive resin composition of the present invention may be any method known conventionally as a coating method using a roller coater. Typical methods include e.g. methods using a doctor bar roller coater, a doctor roller coater or a reverse roller coater.

One example of the method of forming a resist image by use of the radiation sensitive resin composition for roller coating according to the present invention is as follows: The radiation sensitive composition is applied onto a substrate by a roller coater such that the thickness of the resulting film after pre-baking is 1.0 to 3.0 µm, and this radiation sensitive resin composition for roller coating applied onto the substrate is pre-baked on e.g. a hot plate to remove the solvent, thereby forming a radiation sensitive resin film. Then, this radiation sensitive resin film is exposed in a usual manner and subjected as necessary to post-exposure baking, followed by development, whereby a positive resist image can be obtained.

### Best Mode for carrying the Invention

Hereinafter, the present invention is described in more detail by reference to the Examples and Comparative Examples, but these examples are merely illustrative of the present invention and not intended to limit the mode of the present invention.

### Synthetic Example 1. Synthesis of novolak resin

100 parts by weight of mixed cresols consisting of m-cresol/p-cresol (mixing ratio of 6/4), 56 parts by weight of 37 weight-% formaldehyde and 2 parts by weight of oxalic acid were charged and the mixture was reacted at a reaction temperature of 100°C for 5 hours. The molecular weight of the novolak resin obtained was 15,200 as determined by polystyrene standards.

### Synthetic Example 2. Synthesis of a photosensitizer

2,3,4-trihydroxybenzophenone and 1,2-naphthoquinonediazide-5-sulfonyl chloride were dissolved in dioxane at a compounding ratio (molar ratio) of 1/2.5 and esterified using triethylamine as a catalyst in a usual manner to give a photosensitizer.

### Examples 1 to 3

100 parts by weight of the novolak resin obtained in Synthetic Example 1, 15 parts by weight of the photosensitizer obtained in Synthetic Example 2 and Megafac F-142D (Dainippon Ink and Chemicals, Inc.) as a nonionic fluorine-based surface active agent was dissolved in propylene glycol monomethyl ether acetate in the amount (ppm) shown in Table 1 to 1.00 part by weight in total of the novolak resin and the photosensitizer, stirred, and filtered through a 0.2 µm filter to obtain the radiation sensitive resin compositions in Examples 1 to 3.

Each of these compositions was applied onto a 300mm × 400 mm glass substrate with chromium layer by a roller coater (RC-353-P) manufactured by Dainippon Screen Mfg. Co., Ltd. The state of the radiation sensitive resin composition on a roller (state of a roller) before transfer to the substrate was observed by the eye. Further, the state of stripe unevenness on the coating film just after coating was also observed by the eye.

Thereafter, it was baked at 100 °C for 90 seconds on a hot plate to obtain an about 1.8 µm resist film. The thickness of the film was measured by a film thickness measuring meter (Lambda Ace) manufactured by Dainippon Screen Mfg. Co., Ltd. Further, the thickness of the film at 100 points in the coating area was measured, and the difference between the maximum thickness and the minimum thickness thereof was measured as scattering of film thickness in the coating area.

In these observations and measurements, evaluation was made on the basis of the following judgment criteria. The results are shown in Table 1.

### (Judgement criteria in observation and measurement)

(1) State of a roller
   ○ No repelling observed.
   × Repelling observed.
(2) Stripes on the coating film
   ○ No stripes observed.
   △ Stripes are to disappear.
   × Stripes observed.
(3) Deviation of film thickness
   ○ less than 2500 Å
   △ 2500 to 4500 Å
   × more than 4500 Å

### Example 4

A radiation sensitive resin composition was prepared in the same manner as in Example 1 except that Megafac F-472 (Dainippon Ink and Chemicals, Ltd.) was used in an amount of 600 ppm in place of Megafac F-142D. The state of a roller, the state of stripe unevenness of the coating film and the scattering of film thickness were evaluated in the same manner as in Example 1, and the results shown in Table 1 were obtained.

### Example 5

A radiation sensitive resin composition was prepared in the same manner as in Example 1 except that Fluorad FC-170C (Sumitomo 3M Ltd.) was used in an amount of 600 ppm in place of Megafac F-142D. The state of a roller, the state of stripe unevenness of the coating film and the scattering of film thickness were evaluated in the same manner as in Example 1, and the results shown in Table 1 were obtained.

### Example 6

A radiation sensitive resin composition was prepared in the same manner as in Example 1 except that Polyflow KL-245 (Kyoeisha Kagaku Ltd.) was used in an amount of 600 ppm in place of Megafac F-142D. The state of a roller, the state of stripe unevenness of the coating film and the scattering of film thickness were evaluated in the same manner as in Example 1, and the results shown in Table 1 were obtained.

### Comparative Example 1

A radiation sensitive resin composition was prepared in the same manner as in Example 1 except that the surface active agent was not used. The state of a roller, the state of stripe unevenness of the coating film and the scattering of film thickness were evaluated in the same manner as in Example 1, and the results shown in Table 1 were obtained.

### Comparative Example 2

A radiation sensitive resin composition was prepared in the same manner as in Example 1 except that a cationic fluorine-based surface active agent Megafac CAO-1 (trimethyl ammonium salt containing perfluoroalkyl groups, Dainippon Ink and Chemicals, Ltd.) was used in an amount of 600 ppm in place of Megafac F-142D. The state of a roller, the state of stripe unevenness of the coating film and the scattering of film thickness were evaluated in the same manner as in Example 1, and the results shown in Table 1 were obtained.

**Table 1**

| | Amount of surface active agent to 1 part by weight in total of novolak resin and photosensitizer (ppm) | State of a roller | Stripes on a coating film | Scattering of film thickness (Å) |
|---|---|---|---|---|
| Example 1 | 300 | ○ | △ | △ |
| Example 2 | 600 | ○ | ○ | ○ |
| Example 3 | 900 | ○ | ○ | ○ |
| Example 4 | 600 | ○ | ○ | ○ |
| Example 5 | 600 | ○ | △ | △ |
| Example 6 | 600 | ○ | △ | △ |
| Comparative Example 1 | 0 | ○ | × | × |
| Comparative Example 2 | 600 | × | × | × |

### Effect of the Invention

As described hereinbefore, the radiation sensitive resin composition for roller coating according to the present invention can be used to form a radiation sensitive resin film free from coating unevenness even by means of roller coating without using any special method and condition, thereby enabling production of high-quality products having uniform brightness at low cost in production of liquid crystal display elements etc.

### Industrial Applicability

The radiation sensitive resin composition for roller coating according to the present invention is suitable as a resist material used in producing semiconductor integrated circuit elements, color filters, liquid crystal display elements etc.

## Claims

1. A radiation sensitive resin composition for roller coating, which comprises an alkali-soluble resin, a photosensitizer and an nonionic fluorine-based surface active agent.

2. A radiation sensitive resin composition for roller coating, which comprises an alkali-soluble resin, a photosensitizer and an nonionic silicon-based surface active agent.

3. A radiation sensitive resin composition for roller coating according to claim 1, wherein the nonionic fluorine-based surface active agent is a polyalkylene oxide adduct of fluoroalkyl(C₃ to C₁₂) sulfonamide in which fluoroalkyl includes perfluoroalkyl.

4. A radiation sensitive resin composition for roller coating according to claim 1, wherein the nonionic fluorine-based surface active agent is a polyalkylene oxide adduct of fluoroalkyl(C₃ to C₁₂)ethyl alcohol in which fluoroalkyl includes perfluoroalkyl.

5. A radiation sensitive resin composition for roller coating according to claim 1, wherein the nonionic fluorine-based surface active agent is a mixture of (a) a copolymer between an ester of acrylic acid with fluoroalkyl (C₃ to C₁₂)ethyl alcohol in which fluoroalkyl includes perfluoroalkyl, and methyl methacrylate and (b) a polyalkylene oxide.

6. A radiation sensitive resin composition for roller coating according to claim 2, wherein the nonionic silicon-based surface active agent is a polyalkylene oxide adduct of polysiloxane derivative.

7. Amethod of roller-coating a radiation sensitive resin composition, wherein a radiation sensitive resin composition for roller coating described in any one of claims 1 to 6 is applied onto a substrate by a roller coating method.
